# EUROPEAN PATENT SPECIFICATION

(11) **EP 3 548 645 B1**
(45) Date of publication and mention of the grant of the patent: **17.06.2026**
(21) Application number: 17822779.9
(22) Date of filing: 23.11.2017
(51) Int. Cl.: H01J 37/32, H01J 37/34, C23C 14/34, C23C 14/35

(54) **A UNIVERSALLY MOUNTABLE END-BLOCK**
UNIVERSELL MONTIERBARER ENDBLOCK
ENTRETOISE À MONTAGE UNIVERSEL

(30) Priority: 29.11.2016 BE 201605888
(43) Date of publication of application: 09.10.2019
(73) Proprietor: Soleras Advanced Coatings bv, 9800 Deinze (BE)
(72) Inventor: DE BOSSCHER, Wilmert, 9031 Drongen (BE); VAN DE PUTTE, Ivan, 8790 Waregem (BE); DEWILDE, Niek, 9770 Kruishoutem (BE)
(74) Representative: Winger
(86) International application number: PCT/IB2017/057351
(87) International publication number: WO 2018/100473

(56) References cited:
- US-A- 4 407 713
- US-A- 5 200 049
- US-A1- 2008 105 543
- US-A1- 2011 147 209
- US-A1- 2011 240 465

## Description

### Area of application of the invention

The present invention relates generally to an end-block for use in a deposition apparatus for transferring power to a consumable target. More specifically, it relates to an end-block on which a cylindrical consumable target can be mounted, and which does not include a projecting part on the engine housing, making it universally mountable. The invention also comprises a corresponding deposition apparatus.

### Background of the invention

An end-block connects a consumable target in a deposition apparatus with the outside of the deposition apparatus. Such an end-block is typically mountable as a part on the deposition apparatus. In parts of the end-block, the pressure may be higher than in the deposition apparatus. For example, this pressure may be close to atmospheric pressure. Parts that can be removed together with the consumable target, or the removable magnet configuration, are typically not counted as belonging permanently to the end-block.

The main function of the end-block is to support the consumable target and potentially rotate the consumable target around the rotational axis. Since PVD deposition occurs with a gas at low gas pressure, the end-block must be vacuum tight, also during any possible rotation of the consumable target. PVD deposition refers to a physical vapour phase deposition technique, wherein material from a consumable target is deposited on, among other things, a substrate on which a thin layer is to be applied. This PVD deposition may, for example, be sputtering, and in this case the consumable target is often called a 'target' or 'sputtering target'. PVD deposition also comprises vapour deposition or evaporation of the consumable target so as to apply a thin layer to closely positioned surfaces with material derived from, among other things, the consumable target.

Because PVD deposition of a consumable target can generate a lot of heat on the consumable target surface, the consumable target must also be cooled. This is typically done with water or another suitable cooling agent. The cooling agent must be supplied and evacuated via the end-block.

The consumable target should also be supplied with an electric current to bring the consumable target to a certain electrical potential. More specifically, in the end-block, power from the static part of the end-block is transferred to the rotating part of the end-block.

To incorporate all these different functionalities, each end-block must have one or more of the following means: (i) drive means for rotating the consumable target, (ii) a rotatable electrical contact means for obtaining electric current on the consumable target, (iii) one or more bearings (or plain bearings) to mechanically support the consumable target while it rotates around its axis, (iv) one or more rotatable sealing devices for coolant, (v) one or more rotatable vacuum sealing means, and (vi) means for positioning magnets or a series of magnets..

To combine these functionalities, several end-block arrangements already exist in the prior art.

'Double, right-angled end-blocks', such as disclosed in US5096562 and in US2003/0136672, are end-blocks wherein the means for bearing, rotating, energising, cooling and isolation (air, coolant and electrical) are divided between two end-blocks, situated at either end of the sputtering target. 'Right-angled' means that the end-blocks are mounted to the wall that is parallel to the rotational axis of the sputtering target.

'Single, straight-through end-blocks', such as disclosed in US5200049, are end-blocks wherein the means for bearing, rotating, energising, cooling and isolation (air, coolant and electrical) are all combined in one end-block. The sputtering target is thus mounted on the end-block. 'Straight-through' means that the rotational axis of the sputtering target is perpendicular to the wall on which the end-block is mounted.

Hybrid end-block arrangements are also described in US5620577, wherein the end of the sputtering target, located opposite the end of the sputtering target where the end-block is provided, is held by a mechanical support element.

Because different functions are present in an end-block, this has implications for the size of the end-block. Known end-blocks generally have a projecting part in which a part of the motor is housed, so that mounting several end-blocks close to each other is not without its problems.

US20110147209 relates to a housing in which only one function is present, namely the application of a rotation moment to the drive shaft. A motor can be mounted in the housing of US20110147209. A drive shaft is accessible on one side from outside the housing and is connected on this side to a rotating target. On the other side, inside the housing, the drive shaft is connected to an electric motor to transmit a rotation moment to the drive shaft.

There is therefore room for improvement in the design of end-blocks, especially with regard to the integration of different functionalities in the end-block in such a way that the end-block is universally mountable.

### Summary of the invention

It is an object of embodiments of the present invention to provide a good end-block which provides support for various functions and to provide a deposition apparatus employing such an end-block.

The above-mentioned aim is achieved by a device, and arrangement according to the present invention.

In a first aspect, the present invention provides an end-block for use in a deposition apparatus. The end-block has the function of connecting a cylindrical consumable target with magnetic bar, with an outside of the deposition apparatus. The end-block comprises at least the following functionalities: (i) drive means for providing relative movement between the consumable target and magnetic bar, the drive means comprising a driven shaft and (ii) transmission means for transmitting electric current to the consumable target. The end-block is comprised in an end-block housing which is substantially axially symmetric and coaxial with the driven shaft. An end-block housing is a component that includes and encloses the end-block with its functionalities.

In a specific embodiment, the end-block housing is a monolithic piece, e.g., made of a metal such as steel or aluminium. This can be produced, among other things, by boring or milling out a solid block of material.

In an embodiment, the end block housing is connected to a wall (or door, flange or lid) of the vacuum chamber and also provides the vacuum seal of an opening in the vacuum chamber.

The diameter of a circle circumscribing the end-block housing and perpendicular to the driven shaft, is not greater than 2.7 times, preferably no greater than 2.1 times, for example, no greater than 1.6 times, the diameter of a coupling on which the consumable target can be mounted. The diameter of a circle circumscribing the end-block housing and perpendicular to the driven shaft, is, for example, between 1.2 and 2.7 times, preferably between 1.6 and 2.1 times, the diameter of a coupling on which the consumable target can be mounted.

Due to the axle symmetry of the end-block housing, the end-block is universally mountable. Indeed, compared to systems where the engine is placed outside the end-block, an end-block according to embodiments of the present invention does not have protrusions in which engine parts are housed, making it easier to mount in different coater configurations.

In an end-block according to the present invention, the drive means for providing a relative movement between the consumable target and magnetic bar may comprise a consumable target motor and a consumable target drive shaft for driving the consumable target. The consumable target drive shaft is then the driven shaft.

In embodiments of the present invention, the consumable target drive shaft is the same as the one on which the consumable target is mounted. In other embodiments, the consumable target drive shaft and the shaft on which the consumption target is mounted may be two different shafts mounted to each other. Because the consumable target drive shaft is coaxial with the consumable target, the end-block does not have protrusions, making it more easily and universally mountable in different coater configurations. It is further an advantage of the present invention that the consumable target drive shaft not only serves to transfer a rotation moment to the consumable target, but is also used to transfer electric power to the consumable target. The power is transferred from the consumable target drive shaft to the consumable target. For example, this electric power can be applied to generate plasma. It is an advantage of the present invention that the consumable target drive shaft is in alignment with the consumable target rotational axis (when the consumable target is mounted). This makes it possible to make a substantially axially symmetric, or even axially symmetric, end-block. This is in contrast to end-blocks where the engine is not in line with the rotational axis of the consumable target.

It is an advantage of embodiments of the present invention that the end-block is only connected with flexible connections for the supply of energy, and for example, cooling agent such as coolant. Because the drive means for providing a relative movement between consumable target and magnetic bar, for example, the consumable target motor or, as indicated below, the magnetic bar motor, and the power transmission are integrated in the end-block, there is no additional mechanical drive connection needed between the atmospheric side and the end-block that may be in a vacuum. As a result, the end-block can be freely positioned within a vacuum deposition system. The end-block can, for example, be mounted on a robotic arm in a vacuum deposition system.

An end-block, according to embodiments of the present invention, having mounted on it a consumable target, can be used as self-cleaning anode in a reactive deposition process. The consumable target can thus rotate alongside other magnetrons that are continuously used in cathode mode to coat a substrate. The anode magnetron removes material from the process at the back, for example, by sputtering or evaporating, while the exposed consumable target surface remains clean at the front.

In the present invention, the axis of electric power transmission is coaxial with the consumable target drive shaft. It is not obvious to make the electric power transmission axis coaxial with the consumable target drive shaft; this is counter-intuitive. After all, it is not obvious to send an AC signal through an induction-based motor. Precisely because the consumable target drive shaft is coaxial with the consumable target, it is possible to limit the diameter of the end-block. If this coaxiality did not exist, the motor would form a bulge on the end-block. Such an end-block with bulge is no longer universally applicable, and cannot be placed in some places where this is still possible for an end-block according to embodiments of the current invention.

In an end-block according to embodiments of the current invention, the consumable target drive shaft can at least partially be made of electrically conductive material. In such embodiments, no additional conductor needs to be applied to transfer electric power to the consumable target. This is made possible by the power transmission and by the electrically conductive consumable target drive shaft.

An end-block according to embodiments of the present invention may further comprise at least one of the following components: (i) a rotatable electrical contact to obtain electric power on the consumable target, (ii) one or more bearings to mechanically support the consumable target while rotating about its axis, (iii) one or more rotatable sealing devices for a cooling agent, for example coolant, and/or vacuum.

In an end-block according to embodiments of the present invention, the consumable target motor may comprise coils mounted on a static portion of the end-block, and a magnet system mounted on the consumable target drive shaft, the coils and the magnet system being mounted in such a way that by sending an electric current through the coils, a rotation moment can be generated on the consumable target drive shaft.

In embodiments of the present invention, the static portion of the end-block may comprise a disc having at least one cylinder (referred to as the 'original cylinder'), said cylinder being coaxial with the consumable target drive shaft and the disk being perpendicular to the consumable target drive shaft, and wherein the at least one cylinder is located around or within the consumable target drive shaft. In particular embodiments of the present invention, the static portion of the end-block may comprise a disc having at least a first and a second cylinder, both coaxial with the consumable target drive shaft, the first cylinder being located around the consumable target drive shaft, and the second cylinder within the consumable target drive shaft. It is an advantage of embodiments of the present invention that the coils of the consumable target motor can be mounted on the first cylinder and that the power transmission can be mounted on the second cylinder. In particular embodiments, the coils of the consumable target motor may be mounted on the at least one cylinder and the power transmission may be mounted between the at least one cylinder and the consumable target drive shaft.

In the above or alternative embodiments of the present invention, the drive means for providing relative movement between the consumable target and magnetic bar may comprise a magnetic bar motor and a magnetic bar drive shaft to move the magnetic bar within the consumable target. The present invention thus comprises embodiments with only a consumable target motor as sole drive within the end-block, embodiments with only a magnetic bar motor as sole drive within the end-block, and embodiments with both a consumable target motor and a magnetic bar motor as drive within the end-block. In case only a magnet bar motor is provided as drive within the end-block, the end-block comprises (i) a fixed electrical contact, (ii) one or more bearings to mechanically support the magnetic bar system while it rotates around its axis and (iii) one or more rotatable seals for cooling agent; a dynamic vacuum seal is then not required.

In an end-block according to embodiments of the present invention, a magnetic bar motor and a consumable target motor may be arranged in series. The magnetic bar motor can be attached to the static part of the end-block, and the magnetic bar drive shaft can be mounted coaxially with the consumable target drive shaft. Both the consumable target and the magnetic bar can be driven by the end-block. It is an advantage of embodiments of the present invention that the diameter of the end-block is not greater when there are two motors arranged in series present than when there is only one motor present: both motors can be placed one after the other in the longitudinal direction of the driven shaft or shafts. It is an advantage of embodiments of the present invention that directional and/or omni-directional material deposition are possible.

In an end-block according to embodiments of the present invention, the magnetic bar motor may comprise coils mounted on the static part of the end-block, and a magnet system that is mounted on the magnetic bar drive shaft, the coils and the magnet system being mounted such that by sending an electric current through the coils, a rotation moment can be generated on the magnetic bar drive shaft.

In an end-block according to embodiments of the present invention, at least one additional cylinder may be present on the disc, on the side opposite to which the at least one original cylinder is present, the at least one additional cylinder being coaxial with the consumable target drive shaft and wherein a portion of the magnetic bar drive shaft is located around or within the additional cylinder. The coils of the magnetic bar motor can be mounted on the at least one additional cylinder. The at least one additional cylinder can be implemented as a third cylinder and a fourth cylinder. A portion of the magnetic bar drive shaft may be located between the third cylinder and the fourth cylinder.

An end-block according to embodiments of the present invention may further comprise means for positioning individual magnets or a series of magnets in the magnetic bar.

In a second aspect, the present invention provides a deposition apparatus comprising at least one end-block according to embodiments of the first aspect.

A deposition apparatus according to embodiments of the present invention may comprise at least one end-block, the deposition apparatus being adapted so that a consumable target can be placed on the at least one end-block and a substrate can be arranged next to the consumable target.

It is an advantage of embodiments of the present invention that it is possible to provide a, for example cylindrical, substrate alongside the inside with a coating. It is an advantage of embodiments that the diameter of that substrate may have a smaller inner diameter, and still fit around the end-block, than when an end-block is used where the motor is placed outside the end-block. It is an advantage of embodiments of the present invention that internal coating of a hollow substrate is possible. This makes it possible, for example, to make large reflectors. This is particularly advantageous in applications such as coating a mirror for a reflecting telescope. A reflecting telescope may have a mirror with a diameter of several meters; e.g. 6 m or 8 m or much larger. Currently, only flat targets are used for coating such large mirrors that are positioned over a radius of the mirror and which can rotate around the centre of the round mirror. The only drive here is the rotation of the fully flat magnet, which is in the vacuum chamber. A magnetron with a cylindrical target could provide all the advantages of cylindrical targets, but is not possible with the current state of rotating cylindrical magnetrons because of the typical atmospheric character of the rotary drive. This problem is solved by use of an end-block according to embodiments of the present invention, in a deposition apparatus according to embodiments of the present invention.

A deposition apparatus according to embodiments of the present invention may comprise multiple end-blocks, these end-blocks being arranged in a two-dimensional configuration, for example, with parallel consumable target drive shafts. It is an advantage of embodiments of the present invention that a more compact two-dimensional configuration can be realised than when end-blocks are used wherein the motor is placed entirely or partially outside the end-block housing.

In a deposition apparatus according to embodiments of the present invention, substrates may be in multiple directions from the point of view of the consumable target, and the magnetic bar motor may provide multi-direction coating. Such an arrangement can, in particular, for example, be used with a static cylindrical consumable target. The substrates can be arranged in a planetary system around the consumable target.

A deposition apparatus according to embodiments of the present invention can be used in applications where the substrates are not flat and where uniform coating on surfaces having multiple orientations is required.

Particular and preferred aspects of the invention are set out in the accompanying independent and dependent claims. Features of the dependent claims may be combined with features of the independent claims and with features of other dependent claims as appropriate and not merely as explicitly set out in the claims.

The above and other aspects of the invention will be apparent from and elucidated with reference to the embodiment(s) described hereinafter.

### Brief description of the drawings

FIG. 1 to FIG. 6 show, in the longitudinal direction, schematic representations of different configurations of end-blocks, according to embodiments of the present invention.
FIG. 7 shows a representation of an end-block viewed from the consumable target axis, according to embodiments of the present invention.
FIG. 8 shows representations of end-blocks viewed from the consumable target axis, according to the prior art.
FIG. 9a and FIG. 9b show a schematic representation of a portion of a deposition apparatus, according to embodiments of the present invention.
FIG. 10 and FIG. 11 show a schematic representation of a cross-section of a deposition apparatus with multiple end-blocks, according to embodiments of the present invention.
FIG. 12 shows a schematic representation of an end-block comprising a magnetic bar motor and a consumable target motor, according to embodiments of the present invention.
FIG. 13 shows a schematic representation of an end-block comprising a magnetic bar motor and with a static consumable target, according to embodiments of the present invention.
FIG. 14 shows a schematic representation of a deposition apparatus in which a plurality of consumable targets are arranged side by side, each consumable target being mounted on an end-block according to embodiments of the present invention.
FIG. 15 illustrates another embodiment of the present invention, wherein a consumable target can be statically arranged in the centre of a planetary system, the substrate to be coated being the planets arranged around the consumable target. The consumable target is mounted on an end-block according to embodiments of the present invention, and provides, among other things, power to a drive for driving of the magnetic bar in the consumable target.

The drawings are only schematic and are non-limiting. In the figures, the size of some of the elements may be exaggerated and not drawn to scale for illustrative purposes.

Any reference signs in the claims shall not be construed as limiting the scope. In the different drawings, the same reference signs refer to the same or analogous elements.

### Detailed description of illustrative embodiments

Although the present invention will hereinafter be described with respect to particular embodiments and with reference to certain drawings, the invention is not limited thereto but only by the claims. The drawings described are only schematic and are non-limiting. In the drawings, the size of some of the elements may be exaggerated and not drawn to scale for illustrative purposes. The dimensions and the relative dimensions do not necessarily correspond to actual reductions to practice of the invention.

Furthermore, the terms 'first', 'second' and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms 'top', 'bottom', 'above', 'front' and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It should be noted that the term 'comprising', used in the claims, should not be interpreted as being restricted to the means listed thereafter; it does not exclude other elements or steps. They are thus to be interpreted as specifying the presence of the stated features, integers, steps or components as referred to, but does not preclude the presence or addition of one or more other features, integers, steps or components, or groups thereof. Thus, the scope of the expression 'a device comprising means A and B' should not be limited to devices consisting only of components A and B. It means that with respect to the present invention, the only relevant components of the device are A and B.

Reference throughout this specification to 'one embodiment' or 'an embodiment' means that a particular feature, structure or characteristic described in connection with the embodiment is included in at least one embodiment of the present invention. Thus, the appearance of the phrases 'in one embodiment' or 'in an embodiment' in various places throughout this specification do not necessarily all refer to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of illustrative embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein comprise some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

Where reference is made to a consumable target motor in embodiments of the present invention, a motor is meant capable of transferring a rotation moment to a consumable target and whose motor shaft is coaxial with the rotational axis of the consumable target. Such a consumable target can, for example, be a torque motor. These are typically induction motors of toroidal construction. In addition, these motors have the advantage that they can be hollow, making it possible to mount one or more shafts through them. In embodiments of the present invention, the motor may be a water turbine.

Where in embodiments of the present invention, reference is made to a 'magnetic bar motor', an motor is meant by which a rotation moment can be transmitted to a magnetic bar. This can also be a torque motor or a water turbine.

'Axially symmetric', in the context of the present invention, means that the same feature occurs periodically after a certain angular rotation around the axis. 'Substantially axially symmetric' means that there may be minor deviations from the exact axle symmetry, for example, by applying components such as antennas, attachment means, etc., which do not necessarily occur after a certain angular rotation around the axis, but without thereby affecting the universal mountability of the end-block and its housing. The substantially axially symmetric housing does not contain protrusions that interrupt axle symmetry, in which motor parts are housed.

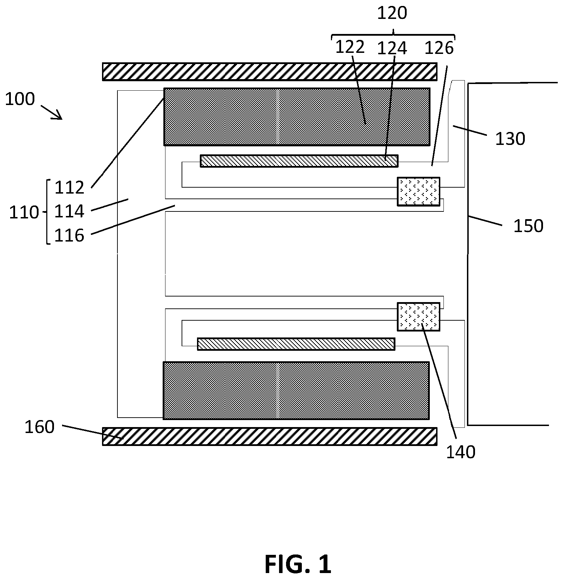

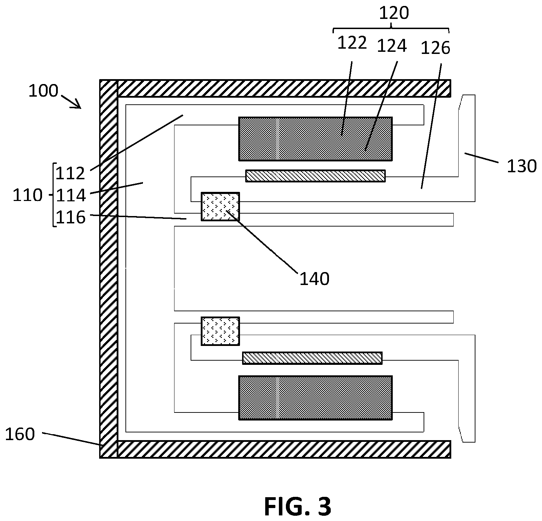

In a first aspect, the present invention provides an end-block for use in a deposition apparatus, for connecting a cylindrical consumable target with magnetic bar, with an outer side of the deposition apparatus. The end-block comprises at least drive means for providing a relative movement between the consumable target and the magnetic bar, the drive means comprising a driven shaft. The drive means comprise a consumable target motor and a consumable target drive shaft, for rotationally driving a consumable target around a magnetic bar (which can stand still, or which may itself perform a movement different from the rotational motion of the consumable target). In alternative embodiments, the drive means may comprise a magnetic bar motor and a magnetic bar drive shaft, for rotationally driving a magnetic bar within a static consumable target. In further alternative embodiments, the drive means may comprise both a consumable target motor and a magnetic bar motor, for rotationally driving a consumable target and a magnetic bar, respectively. The end-block according to the present invention is contained in an end-block housing which is substantially axially symmetric, or even axially symmetric, and coaxial with the driven shaft, which may be the consumable target shaft or the magnetic bar shaft. The diameter of a circle circumscribing the end-block housing and perpendicular to the driven shaft, is not greater than 2.7 times, preferably no greater than 2.1 times, for example, no greater than 1.6 times, the diameter of a coupling on which the consumable target can be mounted. Due to the axle symmetry of the end-block, the end-block is universally mountable. The end-block housing may be open, as illustrated in FIG. 1, FIG. 2 and FIG. 6, or closed, as illustrated in FIG. 3, FIG. 4 and FIG. 5.

In a particular embodiment, the present invention provides a universally mountable end-block 100 for driving a cylindrical consumable target 150. The end-block comprises a static part 110 to which a consumable target motor 120 is attached. This consumable target motor 120 can transmit a rotation moment to a consumable target 150 when that consumable target is mounted on the end-block 100. In order to be able to transmit the rotation moment, the consumable target motor 120 comprises a consumable target drive shaft 126 for driving the consumable target 150. This consumable target drive shaft is coaxial with the rotational axis of the consumable target when the consumable target is mounted on the end-block. In embodiments of the present invention, the consumable target drive shaft 126 is connected to the consumable target during operation of the end-block, so that the consumable target motor can exert a rotation moment on the consumable target. In addition, an end-block, according to embodiments of the present invention, comprises a power transmission 140. This power transmission 140 is adapted to transmit electric power from outside the end-block 100 to the consumable target drive shaft 126. For this purpose, an electrically conductive contact can be made between an electric power source and the consumable target drive shaft. The electric contact with the consumable target drive shaft may be, for example, a sliding contact. The power transmission can consist of multiple distributed elements. In embodiments of the present invention, the consumable target drive shaft is adapted to transmit that electric power to the consumable target 150.

In embodiments of the present invention, the consumable target drive shaft 126 is a hollow shaft. This allows for a flexible configuration of the end-block 100. Thus, the static part of the end-block 110 may have a part on the inside of the consumable target drive shaft and a part on the outside of the consumable target drive shaft. As will be seen below, this offers various possibilities for the installation of the coils of the motor and of the power transmission. In addition, a hollow consumable target drive shaft has the advantage that an additional shaft can be passed through it, for example, for driving a magnetic bar in the consumable target.

In embodiments of the present invention, the consumable target drive shaft 126 is made entirely or partially of electrically conductive material, so that it is possible to transmit electric power coming from the power transmission to the consumable target.

In embodiments of the present invention, the end-block 100 comprise a bearing, to enable rotation of the consumable target drive shaft, and seals, to allow a vacuum in the deposition system on which the end-block is mounted, and seals, to allow refrigeration by a cooling agent.

In embodiments of the present inventions, the various components that contribute to the functionality of the end-block are integrated in the same housing 160. These components are, for example: the consumable target motor 120, the power transmission 140, the bearing, the cooling circuit. Because the consumable target drive shaft 126 is coaxial with the consumable target 150 (when mounted), it is possible to build a substantially axially symmetric end-block. This is in contrast to end-blocks known in the prior art, where the motor shaft is not coaxial with the drive shaft of the consumable target, and may not even be within the housing of the end-block. It is an advantage of embodiments of the present invention that the end-block is substantially axially symmetric. It is an advantage of embodiments of the present invention that there are no protrusions on the housing. The housing 160 may be, for example, cylindrical, or, on the other hand, it may be, for example, quadrangular, hexagonal, or octagonal. For example, the housing may be a milled out steel structure.

FIG. 1 shows a schematic representation of an end-block 100, according to embodiments of the present invention. This figure shows a static part 110 and a consumable target motor 120. The consumable target motor 120 is attached to the static part 110, and the consumable target drive shaft 126 is coaxial with the rotational axis of the consumable target 150. The consumable target drive shaft 126 comprises a coupling 130 on which the consumable target 150 can be mounted. In embodiments of the present invention, the diameter of a circle circumscribing the end-block housing 160 around the drive shaft or consumable target axis is no greater than 2.7 times, for example, no greater than 2.1 times, the diameter of the coupling 130, or even no greater than 1.6 times the diameter of the coupling 130, or even no greater than 1.2 times the diameter of the coupling 130. The coupling 130 may, for example, have a diameter of 133 mm and the diameter of a circle circumscribing the end-block housing 160 may then, for example, have a diameter of 212 mm (for a factor of 1.6 times); if it is a beam-shaped housing with equal sides in a cross-section perpendicular to the drive shaft, this means that each side will have, e.g., a length of less than 150 mm.

In FIG. 1, the static part 110 comprises a disc 114. This is perpendicular to the rotational axis. Perpendicular to this disc is a first cylinder 112 and a second cylinder 116. Both are coaxial with the consumable target drive shaft 126. The first cylinder 112 is located around the consumable target drive shaft 126 and the second cylinder 116 is located inside the consumable target drive shaft.

In embodiments of the present invention, the consumable target motor 120 comprises coils 122, a magnet system 124, and a consumable target drive shaft 126. In this example, the coils are mounted on the static part, for example, the first cylinder 112 and the magnet system 124 is mounted on the moving part, for example, the consumable target drive shaft 126. In other embodiments, however, this may also be reversed, i.e., coils 122 on the moving part and magnet system 124 on the static part. In FIG. 1, the power transmission 140 adapted to transmit electric power from outside the end-block 100 to the consumable target drive shaft 126 is also schematically represented. In this figure, the power transmission 140 is arranged between the second cylinder 116 and the consumable target drive shaft 126.

In embodiments of the present invention, the power transmission 140, which is adapted to transmit electric power from outside the end-block 100 to the consumable target drive shaft 126, additionally comprises one or more elements for providing the electromagnetic shielding between the motor and the consumable target. This avoids interference between the motor and the consumable target. This has the advantage of avoiding that alternating currents through the coils of the motor affect the plasma.

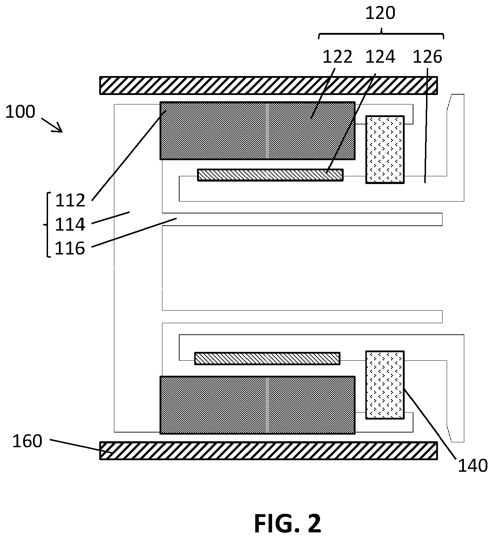

In FIG. 2, the power transmission 140 is arranged between the first cylinder 112 and the consumable target drive shaft 126.

In FIG. 3, the power transmission 140 is arranged between the second cylinder 116 and the consumable target drive shaft 126. Where in FIG. 1., the coils and magnet system 124 were placed closer to the disc 114, in FIG. 3, the power transmission 140 is placed closer to the disc 114.

In embodiments of the present invention, there is no electrical contact between the coils 122 of the motor and the consumable target drive shaft 126. This prevents the coils from reaching the consumable target voltage. In addition, the coils are always isolated from direct electrical contact with the electric power that is led to the consumable target.

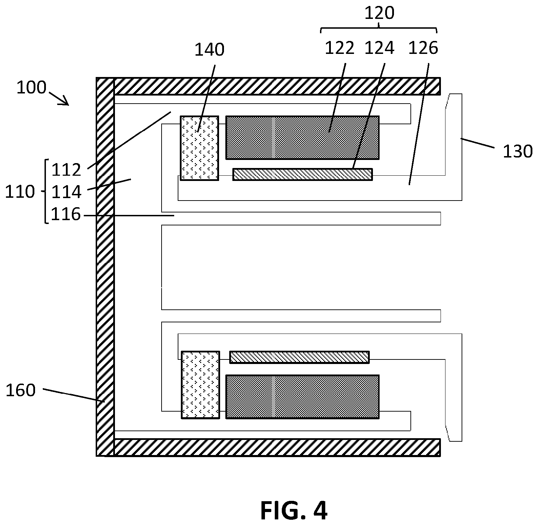

In FIG. 4, the power transmission 140 is arranged between the first cylinder 112 and the consumable target drive shaft 126. Where in FIG. 2 the coils and magnet system 124 were placed closer to the disc 114, in FIG. 4 the power transmission 140 is placed closer to the disc 114.

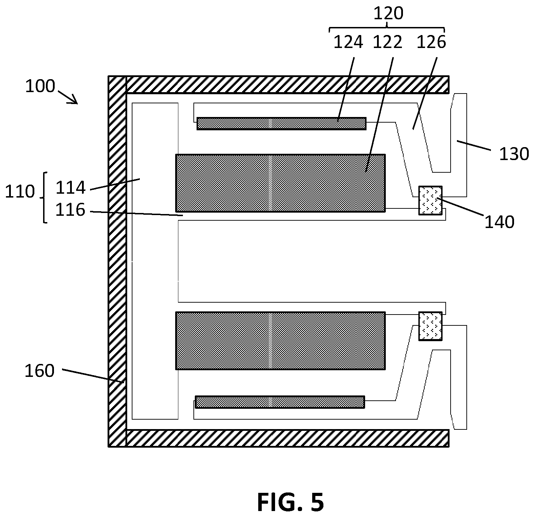

In the end-block 100, which is schematically represented in FIG. 5, only the second cylinder 116 is present on the disc 114. This cylinder is coaxial with the consumable target drive shaft 126. In this example, the consumable target drive shaft 126 is positioned around the second cylinder 116. In FIG. 5, the power transmission 140 is arranged between the first cylinder 114 and the consumable target drive shaft 126. The coils 122 of the consumable target motor 120 are mounted on the static part, for example, on the second cylinder 116. The magnet system 124 is mounted on the moving part, for example, the consumable target drive shaft 126. In alternative embodiments, the coils 122 may be mounted on the moving part, while the magnet system 124 is mounted on the static part.

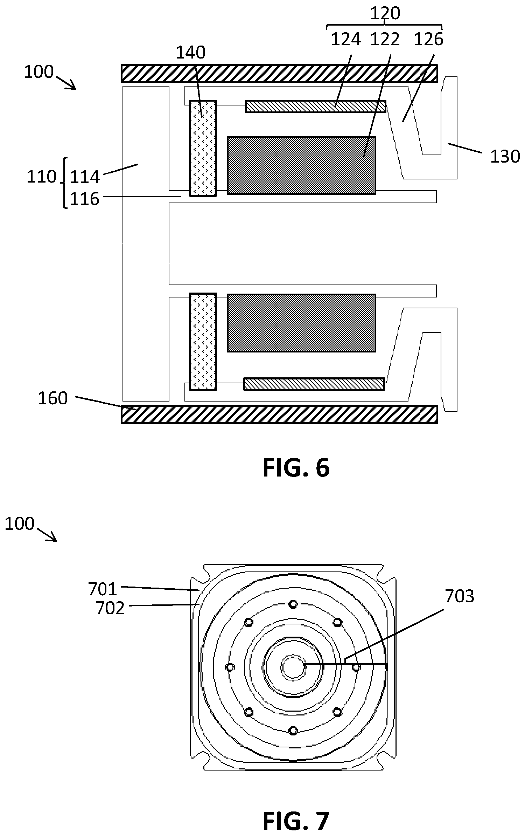

FIG. 6 shows, like FIG. 5, an end-block with a disc 114 having only the second cylinder 116 thereon. Where in FIG. 5, the coils and magnet system 124 were placed closer to the disc 114, in FIG. 6 the power transmission 140 is placed closer to the disc 114.

FIG. 7 shows a representation of an end-block 100 viewed from the consumable target axis, according to embodiments of the present invention. In this embodiment, the end-block is on the atmospheric side and is hidden behind a mounting flange 701. The recesses in the corners allow mounting on the vacuum chamber via a wall, lid, door or other transition piece or flange. Subsequently, vacuum seal means are provided 702, e.g. for an O-ring. The other circles 703 in this figure refer to, among other things, the opening in the housing 160, interface for mounting of a consumable target, openings for conducting the cooling agent, for example, the coolant, and the magnetic bar shaft.

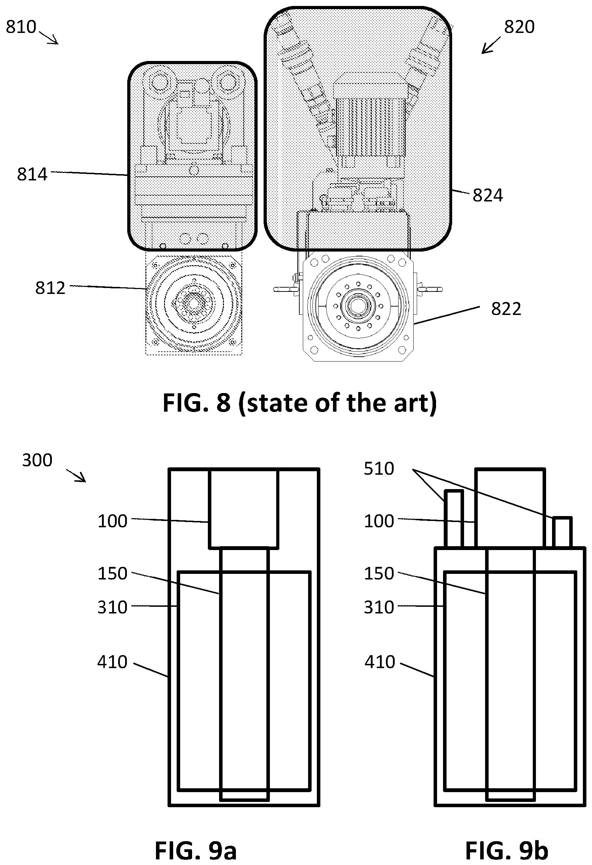

For comparison, in FIG. 8, end-blocks according to the prior art are shown. In FIG. 7, the consumable target motor is integrated in the end-block, according to embodiments of the present invention. This end-block is similar in size to the consumable target holders 812, 822 of FIG. 8. The end-blocks in FIG. 8, however, still include a protruding part where the motor is located. As a result, these end-blocks occupy more space than an end-block according to embodiments of the present invention. The left-hand drawing of FIG. 8 shows a compact end-block 810 with the consumable target holder 812 at the bottom and the motor 814 at the top. The righthand figure shows an axial magnetron 820 with the consumable target holder 822 at the bottom and the motor 824 at the top.

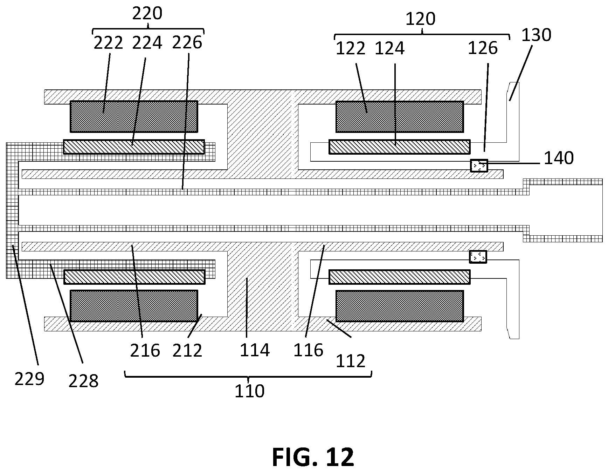

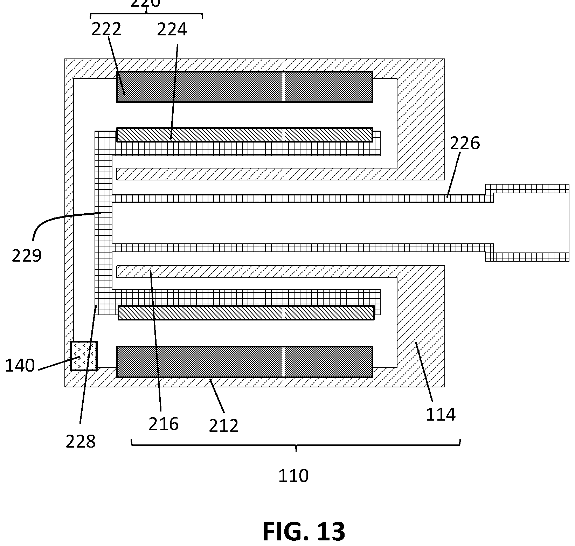

In embodiments of the present invention, a magnetic bar motor 220 is also integrated in the end-block 100. An example of this is shown in the drawings in FIG. 12 and FIG. 13. These drawings show a longitudinal section of an end-block according to embodiments of the current invention.

FIG. 12 shows a static part 110 of the end-block 100 to which a consumable target motor 120 and a magnetic bar motor 220 are attached. The static part 110 comprises a disc 114 having a first cylinder 112 and a second cylinder 116 thereon. The first and the second cylinder 112, 116 are coaxial with the consumable target drive shaft 126. The disc 114 is perpendicular to the consumable target drive shaft 126. A third cylinder 212 and a fourth cylinder 216 are also present on the disc 114. These are located on the side opposite to which the first and second cylinders 112, 116 are located. The third and the fourth cylinder 212, 216 are coaxial with the consumable target drive shaft 126. In embodiments of the present invention, this disc 114 with associated cylinders forms part of the housing. However, such an end-block 100 may also comprise yet another housing (not illustrated in FIG. 12), enclosing the end-block.

In this illustrative embodiment of the present invention, the consumable target motor 120 consists of coils 122, a magnet system 124, and a consumable target drive shaft 126. This consumable target drive shaft is hollow. The first cylinder 112 is located around the consumable target drive shaft 126, and the second cylinder 116 is located within the consumable target drive shaft 126. The coils 122 are mounted on the static part, for example, the second cylinder 112. The magnet system 124 is mounted on the moving part, for example, the consumable target drive shaft 126. In alternative embodiments, this mounting can actually be reversed: magnet system 124 on the static part, for example, the first cylinder 112, and coils 122 on the moving part, for example, the consumable target drive shaft 126. The consumable target drive shaft 126 also comprises a coupling 130 on which a consumable target (not illustrated in FIG. 12) can be mounted. The coils 122 and the magnet system 124 are positioned such that, by electrically energising the coils in a suitable manner, a rotation moment can be applied to the consumable target drive shaft 126.

In this illustrative embodiment of the present invention, the magnetic bar motor 220 consists of coils 222, a magnet system 224, and a magnetic bar drive shaft 226. This magnetic bar drive shaft 226 is arranged in the hollow consumable target drive shaft 126. The magnetic bar drive shaft 226 is positioned such that it can rotate a magnetic bar in the consumable target. A portion of the magnetic bar drive shaft 226 is located between the third cylinder 212 and fourth cylinder 216. In the illustrated example, the magnetic system 224 is arranged on the moving part. The coils 222 are mounted on the static part, and more specifically, in the illustrated example, the third cylinder 212. In alternative embodiments, the magnet system 224 may be mounted on the static part, for example, on the third cylinder 212, while the coils 222 may be mounted on the moving part, for example, the magnetic bar drive shaft 226. The coils 222 and the magnet system 224 are positioned such that, by electrically energising the coils 222 in a suitable manner, a rotation moment can be applied to the magnetic bar drive shaft 226. In this illustrative embodiment of the present invention, the portion of the magnetic bar drive shaft 226 that is located between the third cylinder 212 and fourth cylinder 216 comprises a cylindrical portion 228 that is located on the end 229 of the magnetic bar drive shaft 226 and at least partially encloses the rest of the magnetic bar drive shaft.

FIG. 12 shows, through different cross-hatchings, which parts of the end-block 100 are static (the disc 114 with associated cylinders 112, 116, 212, 216), which parts correspond to the consumable target rotation (coils 122, magnet system 124, consumable target drive shaft 126, coupling 130), and which parts correspond to the magnetic bar rotation (coils 222, magnet system 224, magnetic bar drive shaft 226).

During operation of the deposition apparatus of this example, at least the consumable target drive shaft 126 is at consumable target voltage. A current flows through the consumable target drive shaft 126 to the consumable target for the plasma. In this illustrative embodiment of the present invention, the power transmission 140, which is adapted to transmit electric power from outside the end-block 100 to the consumable target drive shaft 126, comprises a brush system. The brush system is adapted to transmit the electric power of the portion 114, 116, 216 of the static part in which no coils are present to the coupling 130 for mounting the consumable target.

FIG. 13 illustrates an alternate embodiment, in which the components responsible for the magnetic bar rotation (magnet system 224, magnetic bar drive shaft 226, and its end 229), are rotationally arranged, while parts related to the consumable target are static (the disc 114 with associated cylinders 212, 216). The consumable target can be attached to a connecting piece (not illustrated in FIG. 13) attached to disc 114.

In this illustrative embodiment of the present invention, the magnetic bar motor 220 consists of coils 222, a magnet system 224, and a magnetic bar drive shaft 226. This magnetic bar drive shaft 226 is arranged in the hollow, but static, consumable target. The magnetic bar drive shaft 226 is positioned such that it can rotate a magnetic bar in the consumable target. A portion of the magnetic bar drive shaft 226 is located between the third cylinder 212 and fourth cylinder 216 (in this embodiment, there is not necessarily a first and second cylinder present, but for consistency of terminology, the same naming is used as in previous embodiments). On the moving part, for example, on the magnetic bar drive shaft 226, the magnet system 224 is arranged. The coils 222 are mounted on the static part, for example, on the third cylinder 212. In alternate embodiments, coils 222 and magnet system 224 may change places relative to each other, so that the magnet system 224 is mounted on the static part, for example, the third cylinder 212, and the coils 222 on the moving part, for example, the magnetic bar drive shaft 226. The coils 222 and the magnet system 224 are positioned such that, by electrically energising the coils 222 in a suitable manner, a rotation moment can be applied to the magnetic bar drive shaft 226. In this illustrative embodiment of the present invention, the portion of the magnetic bar drive shaft 226 that is located between the third cylinder 212 and fourth cylinder 216 comprises a cylindrical portion 228 that is located on the end 229 of the magnetic bar drive shaft 226 and at least partially encloses the rest of the magnetic bar drive shaft.

In order to provide power transmission to the consumable target, a power transmission 140 is provided. Since the consumable target in this embodiment is statically arranged, the power transmission 140 may also be static, for example - but not limited to - a screwed electrical connection. The power transmission 140 may be within the third cylinder 212, as illustrated in FIG. 13, which allows the third cylinder to function as an axially symmetric housing. Alternatively (not illustrated in FIG. 13), the power transmission may also be provided outside the third cylinder, however, within the axially symmetric end-block housing then surrounding the end-block 100.

In a second aspect, the present invention provides a deposition apparatus wherein the deposition apparatus comprises at least one end-block according to embodiments of the present invention.

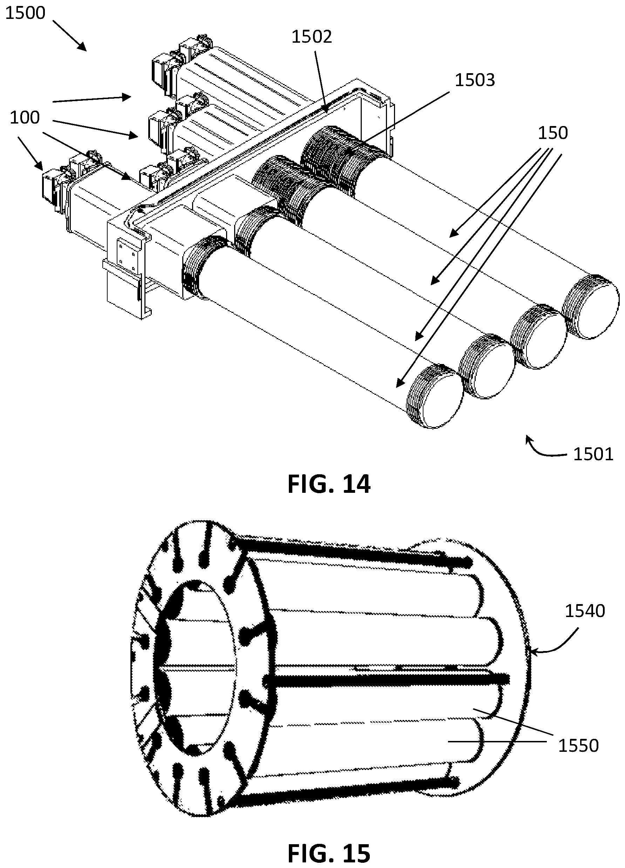

FIG. 9a and FIG. 9b show schematic representations of a portion of a deposition apparatus 300 according to embodiments of the present invention. A side view parallel to the longitudinal axis of the consumable target is shown. These figures show an end-block 100 on which a consumable target 150 is mounted. A substrate 310 is placed around the consumable target 150 and the end-block 100. In these examples, the substrate is a cylindrical substrate and is mounted such that it can be sputtered on its inside. In FIG. 9a, the end-block 100 is fully within the vacuum chamber 410, without risk of interference with the housing or attachment points of the cylindrical substrate 310; which may also rotate around its axis. In FIG. 9b, however, the vacuum chamber 410 is smaller and an end-block 100 is mounted on the atmospheric side. Possible connection flanges, inspection windows or reinforcement ribs 510 can be attached to the outer wall of the vacuum chamber and now, too, interference can be avoided by the compact end-block dimensions. Furthermore, any combination is possible between features of FIG. 9a and FIG. 9b, so that the end-block 100 is partially located along the atmospheric side and partially along the vacuum side of the deposition apparatus. Such a mixed arrangement can also be seen in FIG. 14.

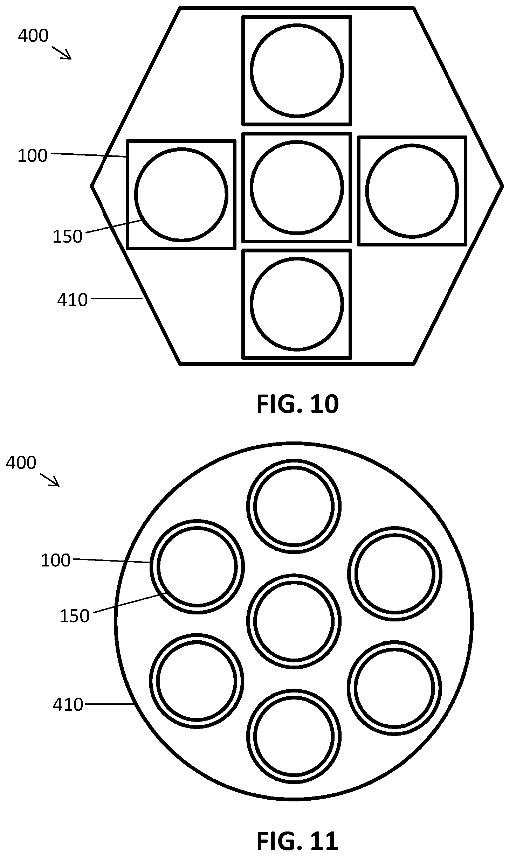

FIG. 10 shows a schematic representation of a deposition apparatus 400 with multiple end-blocks according to embodiments of the present invention. In this example, a view is shown perpendicular to the rotational axis of a consumable target. The figure shows a vacuum chamber wall or vacuum cover plate 410 with a hexagonal shape. Inside this, different end-blocks 100 are positioned, with a consumable target 150 on each end-block. In this situation, it would not be possible to use an end-block for the middle end-block whose motor is not coaxial with the consumable target. After all, the end-blocks around the middle end-block would prevent the positioning.

A similar deposition apparatus is shown in FIG. 11. In this case, the wall or cover plate of the deposition apparatus is circular. Here too, it is not possible to mount the middle consumable target by means of an end-block whose motor is not coaxial with the consumable target.

FIG. 14 illustrates a deposition apparatus 1500 in which various consumable targets 150, each mounted on an end-block 100 according to embodiments of the present invention, are provided. The end-blocks 100 according to embodiments of the invention, given their axle symmetry and the small diameter of the circle circumscribing the end-block perpendicular to the driven shaft, allow the consumable targets 150 to be placed relatively close to each other. Mounting of the end-blocks 100 does not pose a problem, even if the bottom plate 1501 or the top plate (not shown) of the deposition system 1500, or both, would continue under or above the end-blocks. In the illustrated deposition apparatus 1500 different end-blocks 100 are shown, shorter and longer ones. For example, the shorter end-blocks may be end-blocks in which only a consumable target motor is provided, while the longer end-blocks may be, for example, end-blocks in which both a consumable target motor and a magnetic bar motor are placed one after the other, as shown, for example, in FIG. 12, are provided. Providing both the consumable target motor and the magnetic bar motor within the same end-block does not detract from the axle symmetry of the end-block.

Due to their substantially axially symmetric shape, if desired, the end-blocks 100 can be pushed further or less far away through a wall 1502 of a vacuum chamber of the deposition apparatus 1500. This makes it possible to position consumable targets 150 further away from the inside of the wall 1502, which may be relevant, for example, if the substrate which is to be sputtered on is or will be further away from that wall. The deeper insertion into the vacuum chamber of consumable targets 150 and their corresponding end-block 100, as illustrated in the two front end-blocks 100 in FIG. 14, avoids the need to use spacers 1503, as illustrated in the two rear end blocks 100 in FIG. 14.

FIG. 15 illustrates a further embodiment of the present invention, wherein a static cylindrical consumable target, provided with a magnet bar which can be rotationally driven within the static consumable target, can be provided amidst a series of substrates to be sputtered onto, and which are arranged in a planetary system around the static consumable target. The consumable target is mounted on an end-block according to embodiments of the present invention. Such a system can be used for omni-directional PVD deposition on substrates. At least one of both circular flanges sealing the substrate holder 1540 has an opening through which at least one consumable target can be slid. This substrate holder typically contains a planetary drive system through which each of the smaller substrate holder drums 1550 can be rotated to obtain a uniform coating on each component. Possibly, the total substrate holder 1540 can rotate around its axis. The end-block or end-blocks 100 according to embodiments of the present invention, may be mounted fixedly in the wall of the deposition apparatus with the substrate holder 1540 mounted around them.

The various aspects can easily be combined with each other, and the combinations thus also correspond with embodiments according to the present invention.

The various aspects of the present invention may be applied in a variety of applications. For example, in addition to the above-mentioned applications, and without being limited thereto, end-blocks according to embodiments of the present invention may be advantageously used in systems for double-sided coating through a single passage, such as, for example, described in US8092657, wherein the various end-blocks cannot only easily be placed relatively close to each other without protrusions on one end-block hindering the positioning of another end-block, but wherein the end-blocks can furthermore easily be provided with drive means that can independently from each other provide for a relative movement between consumable target and magnetic bar, e.g., which can independently of each other drive the consumable targets in a rotational motion.
The end-blocks according to embodiments of the present invention may also be advantageously applied in systems with moving cathodes, as described, for example, in WO2016/005476.

## Claims

1. An end-block (100) for use in a deposition apparatus, for connecting a cylindrical consumable target (150) with magnetic bar, with an outside of the deposition apparatus, the end-block comprising drive means to provide a relative movement between consumable target and magnetic bar, the drive means comprising a driven shaft wherein an end-block housing (160) containing the end-block (100) is substantially axially symmetric and coaxial with the driven shaft,
wherein the drive means for providing a relative movement between the consumable target and the magnetic bar comprises a consumable target motor (120) and a consumable target drive shaft (126), coaxial with the consumable target, for driving the consumable target (150),
the end-block comprises electrical power transmission means (140) to transmit electric power to the consumable target
**characterized in that**
the consumable target drive shaft (126) is adapted to transmit electrical power to the consumable target (150).

2. The end-block according to claim 1, wherein the diameter of a circle circumscribing the end-block housing and perpendicular to the driven shaft, is not greater than 2.7 times, preferably no greater than 2.1 times, for example, no greater than 1.6 times, the diameter of a coupling on which the consumable target can be mounted.

3. The end-block (100) according to any of the previous claims, the consumable target drive shaft (126) at least partially being made of electrically conductive material.

4. The end-block according to any of the previous claims, which further comprises at least one of the following parts (i) a rotatable electric contact to obtain electric power on the consumable target, (ii) one or more bearings to support the consumable target mechanically while it rotates around its axis, (iii) one or more rotatable sealing devices for cooling agent and/or vacuum.

5. The end-block (100) according to any of the previous claims, the consumable target motor (120) comprising coils (122) mounted on a static portion (110) of the end-block (100), and comprising a magnet system (124) mounted on the consumable target drive shaft (126), the coils and the magnet system (124) being mounted in such a way that by sending an electric current through the coils, a rotation moment can be generated on the consumable target drive shaft (126).

6. The end-block (100) according to claim 5, the static portion comprising a disc (114) having at least one cylinder (112, 116), said cylinder (112, 116) being coaxial with the consumable target drive shaft (126) and the disc (114) being perpendicular to the consumable target drive shaft (126), the at least one cylinder (112, 116) being located around or within the consumable target drive shaft (126).

7. The end-block according to claim 6, the coils (122) of the consumable target motor (120) being mounted on the cylinder (112, 116) and the power transmission (140) being mounted between the cylinder (112, 116) and the consumable target drive shaft (126).

8. The end-block according to any of the preceding claims, the drive means for providing a relative movement between the consumable target and magnetic bar comprising a magnetic bar motor (220) and a magnet bar drive shaft (226) for moving the magnetic bar within the consumable target.

9. The end-block (100) according to claim 8, in so far as dependent on claim 3, the magnetic bar motor (220) being placed in series with the consumable target motor (120), the magnetic bar motor being attached to the static part (110), and the magnet bar drive shaft (226) being mounted coaxial with the consumable target drive shaft (126).

10. The end-block (100) according to claim 8 or 9, the magnetic bar motor comprising coils (220) mounted on the static part (110) of the end-block (100), and comprising a magnet system (224) that is mounted on the magnetic bar drive shaft (226), the coils (222) and the magnet system (224) being mounted such that by sending an electric current through the coils, a rotation moment can be generated on the magnetic bar drive shaft (226).

11. The end-block (100) according to any of claims 9 or 10, in so far as dependent on claim 6, with at least one additional cylinder (212, 216) present on the disc (114) on the side opposite to which the at least 1 original cylinder (112, 116) is present, the additional cylinder (212, 216) being coaxial with the consumable target drive shaft (126), and a portion of the magnet bar drive shaft (226) being located around or within the additional cylinder (212, 216).

12. A deposition apparatus (300), comprising at least one end-block (100) according to any of the preceding claims.

13. The deposition apparatus (300) according to claim 12, the deposition apparatus comprising at least one end-block (100), the deposition apparatus (300) being adapted such that a consumable target (150) can be placed on the at least one end-block (100) and a substrate (310) can be arranged next to the consumable target (150).

14. The deposition apparatus (400) according to any of the claims 12 or 13, the deposition apparatus comprising a plurality of end-blocks, and these end-blocks being arranged in a two-dimensional configuration with parallel consumable target drive shafts.

## Patentansprüche

1. Ein Endblock (100) zur Verwendung in einer Abscheidungseinrichtung, zum Verbinden eines zylindrischen Verbrauchsziels (150) mit Magnetstab mit der Außenseite der Abscheidungseinrichtung, wobei der Endblock ein Antriebsmittel umfasst, um eine Relativbewegung zwischen Verbrauchsziel und Magnetstab bereitzustellen, wobei das Antriebsmittel eine angetriebene Welle umfasst, wobei ein Endblockgehäuse (160), das den Endblock (100) enthält, im Wesentlichen axialsymmetrisch und koaxial zur angetriebenen Welle ist,
wobei das Antriebsmittel zum Bereitstellen einer Relativbewegung zwischen dem Verbrauchsziel und dem Magnetstab einen Verbrauchszielmotor (120) und eine Verbrauchszielantriebswelle (126) umfasst, die koaxial zum Verbrauchsziel angeordnet ist, zum Antreiben des Verbrauchsziels (150).
der Endblock elektrische Leistungsübertragungsmittel (140) umfasst, um elektrische Leistung an das Verbrauchsziel zu übertragen
**dadurch gekennzeichnet, dass** die Verbrauchszielantriebswelle (126) angepasst ist, um die elektrische Leistung an das Verbrauchsziel (150) zu übertragen.

2. Der Endblock nach Anspruch 1, wobei der Durchmesser eines Kreises, der das Endblockgehäuse umschreibt und senkrecht zur angetriebenen Welle steht, nicht größer als das 2,7-fache, vorzugsweise nicht größer als das 2,1-fache, beispielsweise nicht größer als das 1,6-fache, des Durchmessers einer Kupplung ist, auf der das Verbrauchsziel montiert werden kann.

3. Der Endblock (100) nach einem der vorstehenden Ansprüche, wobei die Verbrauchszielantriebswelle (126) mindestens teilweise aus elektrisch leitfähigem Material gefertigt ist.

4. Der Endblock nach einem der vorstehenden Ansprüche, der weiter mindestens eines der folgenden Teile umfasst: (i) einen drehbaren elektrischen Kontakt, um elektrische Leistung auf dem Verbrauchsziel zu erhalten, (ii) ein oder mehrere Lager, um das Verbrauchsziel während dessen Drehung um seine Achse zu stützen, (iii) eine oder mehrere drehbare Dichtungsvorrichtungen für Kühlmittel und/oder Vakuum.

5. Der Endblock (100) nach einem der vorstehenden Ansprüche, wobei der Verbrauchszielmotor (120) Spulen (122) umfasst, die an einem statischen Abschnitt (110) des Endblocks (100) montiert sind, und ein Magnetsystem (124) umfasst, das an der Verbrauchszielantriebswelle (126) montiert ist, wobei die Spulen und das Magnetsystem (124) so montiert sind, dass durch Senden eines elektrischen Stroms durch die Spulen ein Drehmoment an der Verbrauchszielantriebswelle (126) erzeugt werden kann.

6. Der Endblock (100) nach Anspruch 5, wobei der statische Abschnitt eine Scheibe (114) umfasst, die mindestens einen Zylinder (112, 116) aufweist, wobei der Zylinder (112, 116) koaxial zur Verbrauchszielantriebswelle (126) ist und die Scheibe (114) senkrecht zur Verbrauchszielantriebswelle (126) steht, wobei sich der mindestens eine Zylinder (112, 116) um oder innerhalb der Verbrauchszielantriebswelle (126) herum befindet.

7. Der Endblock nach Anspruch 6, wobei die Spulen (122) des Verbrauchszielmotors (120) auf dem Zylinder (112,116) montiert sind und die Leistungsübertragung (140) zwischen dem Zylinder (112,116) und der Verbrauchszielantriebswelle (126) montiert ist.

8. Der Endblock nach einem der vorstehenden Ansprüche, wobei das Antriebsmittel zum Bereitstellen einer Relativbewegung zwischen dem Verbrauchsziel und dem Magnetstab einen Magnetstabmotor (220) und eine Magnetstabantriebswelle (226) zum Bewegen des Magnetstabs innerhalb des Verbrauchsmaterials umfasst.

9. Der Endblock (100) nach Anspruch 8, soweit von Anspruch 3 abhängig, wobei der Magnetstabmotor (220) in Reihe mit dem Verbrauchszielmotor (120) platziert ist, wobei der Magnetstabmotor am statischen Teil (110) befestigt ist und die Magnetstabantriebswelle (226) koaxial zur Verbrauchszielantriebswelle (126) montiert ist.

10. Der Endblock (100) nach Anspruch 8 oder 9, der Magnetstabmotor, der Spulen (220) umfasst, die am statischen Teil (110) des Endblocks (100) montiert sind, und ein Magnetsystem (224) umfasst, das auf der Magnetstabantriebswelle (226) montiert ist, wobei die Spulen (222) und das Magnetsystem (224) montiert sind, sodass durch Senden eines elektrischen Stroms durch die Spulen ein Drehmoment auf der Magnetstabantriebswelle (226) erzeugt werden kann.

11. Der Endblock (100) nach einem der Ansprüche 9 oder 10, soweit von Anspruch 6 abhängig, mit mindestens einem zusätzlichen Zylinder (212, 216), der auf der Scheibe (114) auf der Seite vorhanden ist, die jener gegenüberliegt, auf welcher der mindestens 1 ursprüngliche Zylinder (112, 116) vorhanden ist, wobei der zusätzliche Zylinder (212, 216) koaxial mit der Verbrauchszielantriebswelle (126) ist und sich ein Abschnitt der Magnetstabantriebswelle (226) um oder innerhalb des zusätzlichen Zylinders (212, 216) befindet.

12. Eine Abscheidungseinrichtung (300), umfassend mindestens einen Endblock (100) nach einem der vorstehenden Ansprüche.

13. Die Abscheidungseinrichtung (300) nach Anspruch 12, wobei die Abscheidungseinrichtung mindestens einen Endblock (100) umfasst, die Abscheidungseinrichtung (300) angepasst ist, sodass ein Verbrauchsziel (150) auf dem mindestens einen Endblock (100) platziert werden kann und ein Substrat (310) neben dem Verbrauchsziel (150) angeordnet werden kann.

14. Die Abscheidungseinrichtung (400) nach einem der Ansprüche 12 oder 13, wobei die Abscheidungseinrichtung eine Vielzahl von Endblöcken umfasst und diese Endblöcke in einer zweidimensionalen Konfiguration mit parallelen Verbrauchszielantriebswellen angeordnet sind.

## Revendications

1. Un bloc d'extrémité (100) destiné à être utilisé dans un appareil de dépôt, pour connecter une cible consommable cylindrique (150) avec barre magnétique, avec l'extérieur de l'appareil de dépôt, ledit bloc d'extrémité comprenant des moyens d'entraînement pour fournir un mouvement relatif entre la cible consommable et la barre magnétique, lesdits moyens d'entraînement comprenant un arbre entraîné dans lequel un boîtier de bloc d'extrémité (160) contenant ledit bloc d'extrémité (100) est sensiblement axialement symétrique et coaxial avec ledit arbre entraîné, dans lequel lesdits moyens d'entraînement pour fournir un mouvement relatif entre la cible consommable et la barre magnétique comprennent un moteur de cible consommable (120) et un arbre d'entraînement de cible consommable (126), coaxial avec la cible consommable, pour entraîner ladite cible consommable (150), ledit bloc d'extrémité comprend des moyens de transmission de puissance électrique (140) pour transmettre de l'énergie électrique à ladite cible consommable **caractérisé en ce que** ledit arbre d'entraînement de cible consommable (126) est adapté pour transmettre de l'énergie électrique à ladite cible consommable (150).

2. Le bloc d'extrémité selon la revendication 1, dans lequel le diamètre d'un cercle circonscrivant le boîtier du bloc d'extrémité et perpendiculaire audit arbre entraîné, n'est pas supérieur à 2,7 fois, de préférence pas supérieur à 2,1 fois, par exemple, pas supérieur à 1,6 fois, le diamètre d'un accouplement sur lequel ladite cible consommable peut être montée.

3. Le bloc d'extrémité (100) selon l'une quelconque des revendications précédentes, ledit arbre d'entraînement de cible consommable (126) étant au moins partiellement constitué de matériau électriquement conducteur.

4. Le bloc d'extrémité selon l'une quelconque des revendications précédentes, qui comprend en outre au moins une des parties suivantes (i) un contact électrique rotatif pour obtenir de l'énergie électrique sur ladite cible consommable, (ii) un ou plusieurs roulements pour supporter mécaniquement ladite cible consommable pendant qu'elle tourne autour de son axe, (iii) un ou plusieurs dispositifs d'étanchéité rotatifs pour agent de refroidissement et/ou vide.

5. Le bloc d'extrémité (100) selon l'une quelconque des revendications précédentes, ledit moteur de cible consommable (120) comprenant des bobines (122) montées sur une partie statique (110) dudit bloc d'extrémité (100), et comprenant un système d'aimants (124) monté sur ledit arbre d'entraînement de cible consommable (126), lesdites bobines et ledit système d'aimants (124) étant montés de telle manière qu'en envoyant un courant électrique à travers lesdites bobines, un moment de rotation peut être généré sur ledit arbre d'entraînement de cible consommable (126).

6. Le bloc d'extrémité (100) selon la revendication 5, ladite partie statique comprenant un disque (114) ayant au moins un cylindre (112, 116), ledit cylindre (112, 116) étant coaxial avec ledit arbre d'entraînement de cible consommable (126) et ledit disque (114) étant perpendiculaire audit arbre d'entraînement de cible consommable (126), ledit au moins un cylindre (112, 116) étant situé autour ou à l'intérieur dudit arbre d'entraînement de cible consommable (126).

7. Le bloc d'extrémité selon la revendication 6, lesdites bobines (122) dudit moteur de cible consommable (120) étant montées sur ledit cylindre (112, 116) et ladite transmission de puissance (140) étant montée entre ledit cylindre (112, 116) et ledit arbre d'entraînement de cible consommable (126).

8. Le bloc d'extrémité selon l'une quelconque des revendications précédentes, lesdits moyens d'entraînement pour fournir un mouvement relatif entre ladite cible consommable et ladite barre magnétique comprenant un moteur de barre magnétique (220) et un arbre d'entraînement de barre d'aimant (226) pour déplacer ladite barre magnétique à l'intérieur de ladite cible consommable.

9. Le bloc d'extrémité (100) selon la revendication 8, dans la mesure où elle dépend de la revendication 3, ledit moteur de barre magnétique (220) étant placé en série avec ledit moteur de cible consommable (120), ledit moteur de barre magnétique étant attaché à ladite partie statique (110), et ledit arbre d'entraînement de barre d'aimant (226) étant monté coaxialement avec ledit arbre d'entraînement de cible consommable (126).

10. Le bloc d'extrémité (100) selon la revendication 8 ou 9, ledit moteur de barre magnétique comprenant des bobines (220) montées sur ladite partie statique (110) dudit bloc d'extrémité (100), et comprenant un système d'aimants (224) qui est monté sur ledit arbre d'entraînement de barre d'aimant (226), lesdites bobines (222) et ledit système d'aimants (224) étant montés de telle sorte qu'en envoyant un courant électrique à travers lesdites bobines, un moment de rotation peut être généré sur ledit arbre d'entraînement de barre d'aimant (226).

11. Le bloc d'extrémité (100) selon l'une quelconque des revendications 9 ou 10, dans la mesure où elle dépend de la revendication 6, avec au moins un cylindre supplémentaire (212, 216) présent sur ledit disque (114) du côté opposé à celui où ledit au moins 1 cylindre original (112, 116) est présent, ledit cylindre supplémentaire (212, 216) étant coaxial avec ledit arbre d'entraînement de cible consommable (126), et une partie dudit arbre d'entraînement de barre d'aimant (226) étant située autour ou à l'intérieur dudit cylindre supplémentaire (212, 216).

12. Un appareil de dépôt (300), comprenant au moins un bloc d'extrémité (100) selon l'une quelconque des revendications précédentes.

13. L'appareil de dépôt (300) selon la revendication 12, ledit appareil de dépôt comprenant au moins un bloc d'extrémité (100), ledit appareil de dépôt (300) étant adapté de telle sorte qu'une cible consommable (150) puisse être placée sur ledit au moins un bloc d'extrémité (100) et un substrat (310) puisse être disposé à côté de ladite cible consommable (150).

14. L'appareil de dépôt (400) selon l'une quelconque des revendications 12 ou 13, ledit appareil de dépôt comprenant une pluralité de blocs d'extrémité, et ces blocs d'extrémité étant disposés dans une configuration bidimensionnelle avec des arbres d'entraînement de cible consommable parallèles.
